# EUROPEAN PATENT SPECIFICATION

(11) **EP 0 326 260 B1**
(45) Date of publication and mention of the grant of the patent: **17.08.1994**
(21) Application number: 89300381.4
(22) Date of filing: 17.01.1989
(51) Int. Cl.: G03B 17/30, G03F 7/00

(54) **An imaging sheet roll containing photosensitive microcapsules**
Filmrolle, versehen mit photoempfindlichen Mikrokapseln
Rouleau de film pourvu de microcapsules photosensibles

(30) Priority: 29.01.1988 JP 10681/88 U
(43) Date of publication of application: 02.08.1989
(73) Proprietor: SONY CORPORATION, Tokyo 141 (JP)
(72) Inventor: Yui, Yasuji Patents Division, Shinagawa-ku Tokyo 141 (JP); Shirakura, Akira Patents Division, Shinagawa-ku Tokyo 141 (JP)
(74) Representative: Purvis, William Michael Cameron

(56) References cited:
- EP-A- 0 227 041
- EP-A- 0 230 057
- DE-C- 641 854
- FR-A- 828 325
- US-A- 3 894 700
- US-A- 4 672 014
- BRITISH JOURNAL OF PHOTOGRAPHY, vol. 126, no. 51, 21st December 1979, pages 1232-1235, London, GB; L.A. MANNHEIM: "Rethinking the 35mm cartridge"
- IDEM

## Description

The invention relates to an imaging sheet roll containing photosensitive microcapsules.

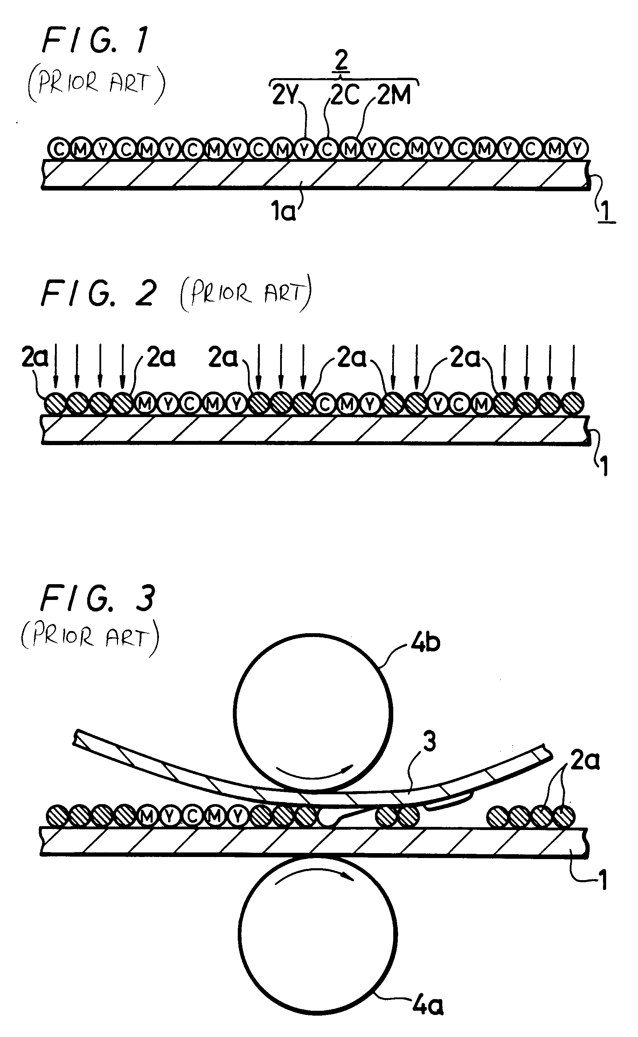

It has previously been proposed to print an image of a colour picture on printing paper by utilizing photosensitive microcapsules. Such a conventional printing method will be first described with reference to schematic illustrations forming Figures 1 to 3 of the accompanying drawings.

Referring initially to Figure 1, a photosensitive film 1 is used which comprises a photosensitive sheet base 1a made of polyethylene telephthalate, polypropylene polyamide for example and a microcapsule layer 2 which comprises a plurality of yellow, magenta and cyan microcapsules 2Y, 2M and 2C and is uniformly coated on the photosensitive sheet base 1a. Each of the yellow, magenta and cyan microcapsules 2Y, 2M and 2C has an outer shell made of a relatively soft material, such as, gelatin, polyvinyl alcohol or gum arabic and a substantive containing an optically-hardenable composition sealed into the inside of each shell. This optically-hardenable composition contains a precursor (or pigment) of pigment such as photochromic dye, electrochromic dye or leuco dye and an ethylene-based unsaturated compound. When the optically-hardenable composition is subjected to irradiation by light of a particular wavelength, it is hardened. Thus each of the yellow, magenta and cyan microcapsules 2Y, 2M and 2C can be hardened. For example, irradiation by blue light hardens the yellow microcapsules 2Y containing the precursor of yellow pigment; irradiation by green light hardens the magenta microcapsules 2M containing the precursor of magenta pigment; and irradiation by red light hardens the cyan microcapsules 2C containing the precursor of cyan pigment, respectively.

Then, with reference to Figure 2, the thus made microcapsule sheet 1 can be irradiated with light of a desired colour picture. In the irradiation by image light, the light of a colour picture is analyzed into three primary colours of red, green and blue, whereby the red image light, the green image light and the blue image light are irradiated separately, thus forming microcapsules respectively hardened by the irradiation of beams of light for respective images as represented by hatched microcapsules 2a in Figure 2. Then a developing-process is performed as shown in Figure 3.

Referring to Figure 3, a developing paper 3 is brought into contact with the microcapsule layer 2 of the microcapsule sheet 1 that has already been irradiated with the image light. The microcapsule sheet 1 and the developing paper 3 are then pinched between rollers 4a and 4b with pressure causing the pressure to break the outer shells of the yellow, magenta and cyan microcapsules 2Y, 2M and 2C that have not been hardened by the irradiation of light having a corresponding wavelength. The substances containing inside the precursors of pigments within the microcapsules are thus transferred to the surface of the developing paper 3. When the precursors of pigments of the respective colours are transferred to the developing paper 3, the surface of the developing paper 3 is developed with the corresponding colours (yellow, magenta and cyan). The mixed condition of the three colours presents a colour picture and the colour picture is developed (or printed) on the developing paper 3.

In general, a length of the photosensitive film 1 is wound in the form of a roll of film around a spool located rotatably within a cassette casing that is arranged to shield the film from light. When it is to be used, the length of photosensitive film 1 is loaded onto a predetermined cassette loading portion of a printer while still within the cassette casing.

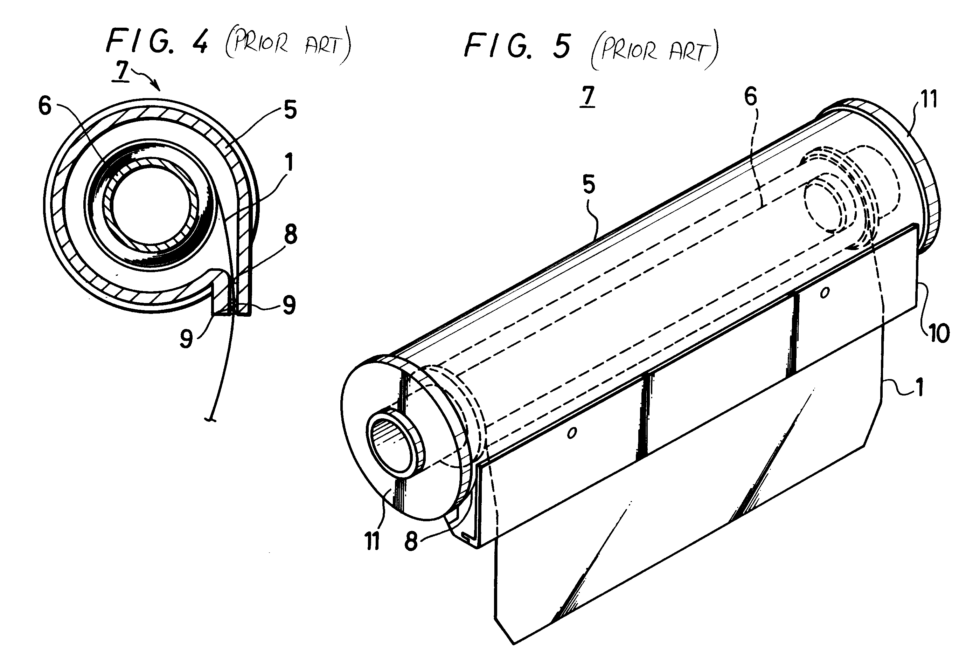

This kind of conventional photosensitive film cassette is constructed as shown in a sectional side view forming Figure 4. As Figure 4 shows, a conventional photosensitive film cassette 7 comprises a cassette casing 5 of a substantially cylindrical configuration, a spool 6 rotatably provided within the cassette casing 5 and around which the length of photosensitive film 1 is wound, a film outlet 8 of a substantially slit configuration extending along an outer peripheral portion of the cassette casing 5 in the axial direction of the cassette casing 5 and pads 9, 9 attached to the two inner side walls of the film outlet 8 and extending in the longitudinal direction of the film outlet 8 to shield the film from light from outside the cassette. The outer end portion of the photosensitive film 1 is withdrawn through the spacing between the opposing surfaces of the light-shielding pads 9, 9 and advanced from the film outlet 8 to be used outside the cassette casing 5, the photosensitive film 1 being pinched between the pads 9, 9 so that the photosensitive film 1 within the cassette is protected from being irradiated with light.

If the light-shielding for the photosensitive film 1 at the film outlet 8 is carried out by the pads 9 and 9 as described above, the photosensitive film 1 shown in Figures 1 to 3 is inevitably acted upon by the pads 9, 9 with a very large friction force in its advancement from the cassette casing 5 with the result that the photosensitive film 1 can be scratched and damaged by the pads 9 and 9, with the microcapsules being broken.

Accordingly, if the pads 9, 9 are arranged to contact with the photosensitive film 1 with only a small pressure in order to protect, as far as possible, the photosensitive film 1 from being damaged, the light-shielding effect at the film outlet 8 is reduced.

Figure 5 which is a perspective view, illustrates the outline of a construction of a previously proposed photosensitive film cassette 7 within which a length of the photosensitive film 1 is wound around the spool 6 in the form of a roll of film and in which the film outlet 8 is formed through the cassette casing 5 to permit withdrawal of the photosensitive film 1. Further, the photosensitive film cassette 7 is provided with a light-shielding member 10 which is rotatably supported by the cassette casing 5 and also grips the photosensitive film 1 drawn from the spool 6 to contact one inner side surface of the film outlet 8 thereby to close the film outlet 8. Spring-biasing means (not shown) spring-bias the light-shielding member 10 such that the light-shielding member 10 closes the film outlet 8 and an engagement portion (not shown) is pressed by a pressing portion of a machine into which the cassette is loaded thereby to move the light-shielding member 10 to a position remote from the inner side surface of the film outlet 8 when the photosensitive film cassette 7 is loaded onto a cassette loading portion of the machine. Flanges 11, 11 are engaged with the opposite ends of the cassette casing 5 rotatably to support the spool 6.

Such a photosensitive film cassette 7, when it is not loaded onto the cassette loading portion has the light-shielding member 10 resiliently engaged with one inner side surface of the film outlet 8 with the photosensitive film 1 gripped therebetween so that light-shielding of the photosensitive film 1 at the film outlet 8 is positively effected. Also, this light-shielding state can be maintained stably. When the photosensitive film cassette 7 is loaded onto the cassette loading portion, the light-shielding member 10 is automatically moved apart from the inner side surface of the film outlet 8 so that the photosensitive film 1 will not be damaged by the light-shielding member 10 as the film is drawn out of the cassette casing 5.

In the arrangements shown in Figures 4 and 5, the photosensitive film cassette 7 needs not only the cassette casing 5 but also the light-shielding pads 9, 9 and the light shielding member 10 for shielding the light. Particularly, use of the photosensitive film cassette 7 requires a complex built-in mechanism to be provided when the light shielding member 10 is employed. This increases the cost of the photosensitive film cassette 7 and the expensive photosensitive film cassette cannot economically be a non-returnable item which is thrown away when empty.

European Published Patent Application EP-A-0227041 discloses a roll cartridge having opposing rollers between which the medium coated with photosensitive microcapsules is discharged.

British Journal of Photography, vol. 126, no. 51, 21st December 1979, pages 1232-1235, London, GB; LA Mannhiem: "Rethinking the 35mm cartridge" discloses a film cartridge having an opaque leader resting within inward facing steps in the spool flanges.

According to the invention there is provided an imaging sheet roll comprising:
a spool with, wound therearound, a photosensitive film in the form of a roll;
a leader tape portion made of an opaque material and bonded to the outer end of the photosensitive film;
spool end holders with flanges provided at opposite ends of the spool; and
inward facing step portions formed in the flanges and on which step portions the leader tape portion of the photosensitive film is wound thereby to shield the photosensitive film from light, characterised in that;
said photosensitive film is coated with photosensitive microcapsules; and
a bonding agent is provided between the step portions and respective side edges of the leader tape portion.

Such an imaging sheet roll containing photosensitive microcapsules can protect the photosensitive film from irradiation by light without using a cassette casing and can be provided at low cost.

Hence it can economically be thrown away after being used.

It can nevertheless be easy to handle.

The invention is diagrammatically illustrated by way of example in the accompanying drawings, in which:-
Figure 1 is a schematic diagram showing a photosensitive film with photosensitive microcapsules coated thereon;
Figure 2 is a schematic diagram showing the exposed state of the photosensitive film of Figure 1;
Figure 3 is a schematic diagram showing printing of photosensitive film;
Figure 4 is a cross-sectional side view of a first example of a photosensitive film cassette of previously proposed kind;
Figure 5 is a perspective view of a second example of a photosensitive film cassette of previously proposed kind;
Figure 6 is a fragmentary, cross-sectional side view of an embodiment of an imaging sheet roll containing photosensitive microcapsules according to the invention;
Figure 7 is a sectional view taken on line A-A' in Figure 6; and
Figure 8 is a perspective view of another embodiment of an end piece of a photosensitive film which can be wound as the imaging sheet roll of Figures 6 and 7.

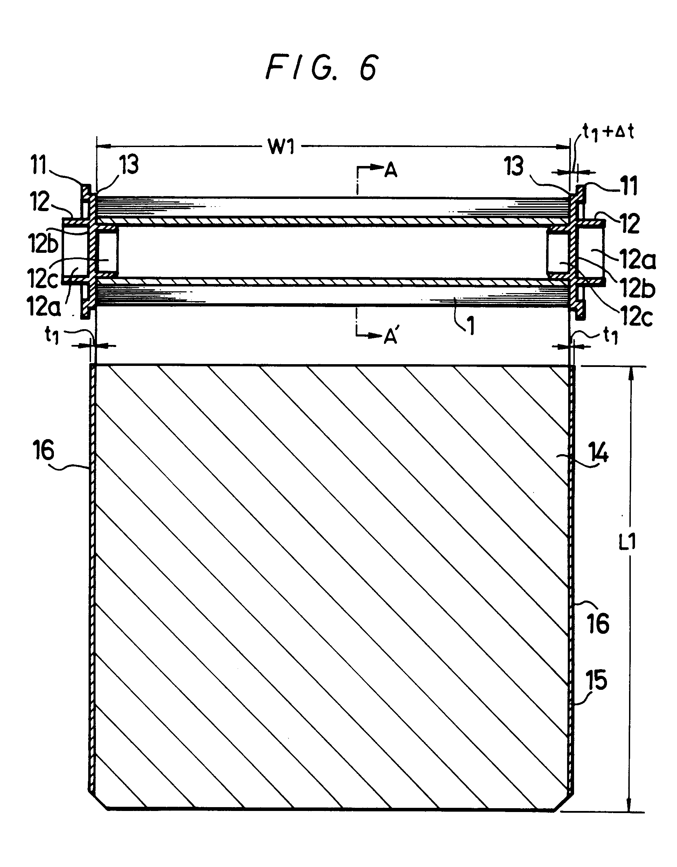

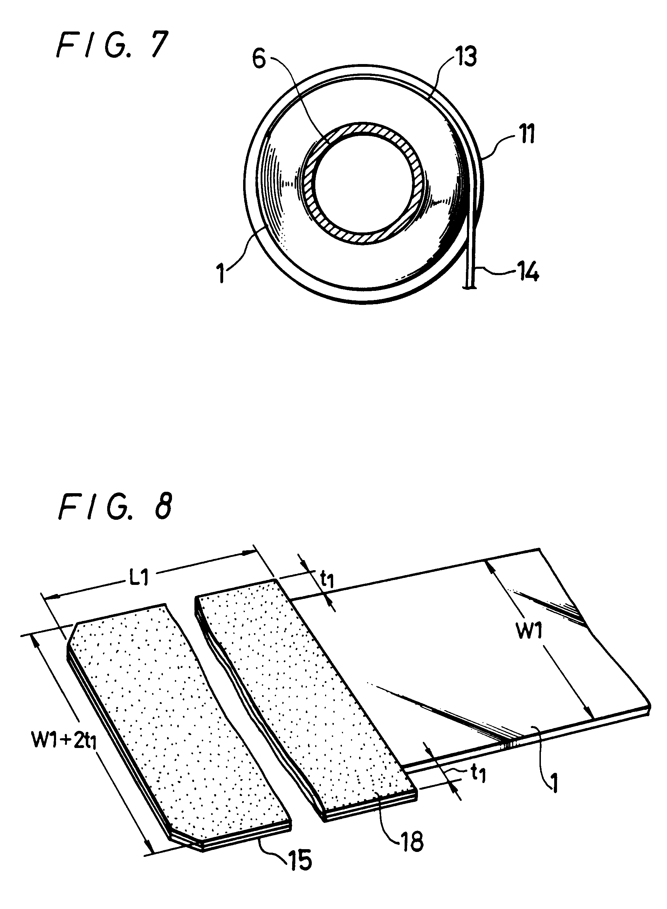

In the embodiment of imaging sheet roll containing photosensitive microcapsules shown in Figures 6 and 7 parts corresponding to those of Figures 4 and 5 are marked with the same references and further explanation is not given.

Referring to Figures 6 and 7, the spool 6 is made of a synthetic resin or cardboard to be of a hollow configuration. Hollow holders 12, 12 having flanges 11, 11 are secured to both ends of the spool 6. Each of the holders 12 comprises, at opposite sides of the respective flange 11, a hollow protruding portion 12c to be inserted into and fixed to the hollow portion of the spool 6 and a protruding bearing portion 12a to be engaged with the shaft of a printing apparatus (not shown). The hollow portion between the protruded portions 12a and 12c can be closed by a blanking disc 12b. In the flange 11, there is provided a step portion 13 which extends toward the protruding bearing portion 12a with a width, t₁ + Δt. The spool 6 and the holders 12, 12 with the flanges 11, 11 could be moulded in one piece of a suitable material such as a synthetic resin. The spool 6 has the photosensitive film 1 wound therearound in the form of a roll. The width of the photosensitive film 1 is selected to be almost as great as the width W1 between the radially inner parts of the flanges 11 and 11. The photosensitive film 1 is similar to that described above in connection with Figures 1 to 3. The outer end of the photosensitive film 1 is bonded to a so-called leader tape 14 made of a material such as black paper or an aluminium-deposited tape that shields the passage of light by either absorbing or reflecting the same to form a leader portion 15. The leader tape 14 has a width which is greater than the width W1 of the photosensitive film 1 by the width t₁ at each of the opposite edges of the leader portion 15. Thus, the width of the leader tape 14 is W1 + 2t₁. The length L1 of the leader tape 14 is selected such that the leader tape 14 can be rolled several times so as to wrap the photosensitive film 1, wound around the spool 6, to a diameter just less than the step portions 13, 13 of the flanges 11, 11, and so that the imaging sheet roll can conveniently be loaded into a printer (not shown). Further, the leader tape 14 is coated at each of its side edges with a strip of bonding agent 16 having a width corresponding to the width t₁ of each of the step portions 13, 13. The bonding agent 16 could be coated on the step portions 13, 13 of the flanges 11, 11 instead of on the leader tape 14. In that case, it would be desirable for the surface of each of the step portions 13 to be made rough so that the bonding agent 16 can be readily peeled off therefrom.

After the photosensitive film 1 has been wound around the spool 6 up to the position of the step portions 13, 13 of the flanges 11, 11, the wider leader tape 14 is then wound around the spool 6 so as to be wrapped around the step portions 13, 13 of the flanges 11, 11. Thus, the leader tape 14 wound on the step portions 13, 13 is bonded to itself owing to the action of the bonding agents 16. As a result, no light passes through the spaces between the end faces of the flanges 11, 11 and the end faces of the wound photosensitive film 1 which are covered by the leader portion 15 of the leader tape 14. The imaging sheet roll containing photosensitive microcapsules thus does not need a cassette casing and can in consequence be very inexpensive, such that it can economically be thrown away after being used.

While the leader tape 14 can be bonded to the tip end portion of photosensitive film 1 as described above, a variant such as is shown in Figure 8 is also possible where the outer end portion of the photosensitive film 1 itself is formed to be wider and on a portion thereof which forms the leader portion 15, there is coated black paint 18 thereby to form a light shield.

Since light can be shielded by the leader portion of the leader tape without a large cassette casing, the imaging sheet roll containing photosensitive microcapsules can be miniaturized in size and can be made inexpensive. Further, the imaging sheet roll containing photosensitive microcapsules of the invention can be thrown away and also made easy to handle.

## Claims

1. An imaging sheet roll comprising:
a spool (6) with, wound therearound, a photosensitive film (1) in the form of a roll;
a leader tape portion (15) made of an opaque material and bonded to the outer end of the photosensitive film (1);
spool end holders (12) with flanges (11) provided at opposite ends of the spool (6); and
inward facing step portions (13) formed in the flanges (11) and on which step portions (13) the leader tape portion (15) of the photosensitive film (1) is wound thereby to shield the photosensitive film (1) from light, characterised in that;
said photosensitive film (1) is coated with photosensitive microcapsules; and
a bonding agent (16) is provided between the step portions (13) and respective side edges of the leader tape portion (15).

2. An imaging sheet roll containing photosensitive microcapsules according to claim 1, in which the spool (6) is made of a hollow configuration and each of the spool end holders (12) is of a hollow configuration.

3. An imaging sheet roll containing photosensitive microcapsules according to claim 2, in which each of the spool end holders has on one of its sides a hollow protruding portion (12a) to be inserted into a respective end of the hollow spool (6) and on the other of its sides a protruding bearing portion (12c) extending in a direction opposite to the hollow protruding portion (12a).

4. An imaging sheet roll containing photosensitive microcapsules according to claim 3, in which each of the hollow holders (12) has a blanking disc (12b) between the hollow protruding portion and the protruding bearing portion (12c).

5. An imaging sheet roll containing photosensitive microcapsules according to any one of claims 1 to 4, in which the material of which the leader tape portion (15) is formed is black paper or an aluminium-deposited tape.

6. An imaging sheet roll containing photosensitive microcapsules according to any one of claims 1 to 5, in which the leader tape portion (15) is coated with the bonding agent (16) at its respective side edges.

7. An imaging sheet roll containing photosensitive microcapsules according to any one of claims 1 to 6, in which the width of the leader tape portion (15) is selected to be the same as the distance between the portions of the flanges (11) radially outwardly of the step portions (13).

8. An imaging sheet roll containing photosensitive microcapsules as claimed in claim 1, in which the leader tape portion (15) comprises a black paint coating (18) on a tip end portion of the photosensitive film (1).

## Patentansprüche

1. Filmrolle umfassend:
eine Spule (6) mit einem um sie herumgewickelten lichtempfindlichen Film (1) in Form einer Rolle;
einen Führungsbandabschnitt (15) aus einem lichtundurchlässigen Material, der mit dem äußeren Ende des lichtempfindlichen Films (1) verbunden ist;
Spulenendenhalterungen (12) mit Flanschen (11), die an den abgewandten Enden der Spule (6) vorgesehen sind; und
nach innen weisende Stufenabschnitte (13), die in den Flanschen (11) ausgebildet sind und auf die der Führungsbandabschnitt (15) des lichtempfindlichen Films (1) gewickelt ist, um den lichtempfindlichen Film (1) vor Licht zu schützen,
dadurch **gekennzeichnet,**
daß der lichtempfindliche Film (1) mit lichtempfindlichen Mikrokapseln beschichtet ist, und ein Haftmittel (16) zwischen den Stufenabschnitten (13) und jeweiligen Seitenkanten des Führungsbandabschnitts (15) vorgesehen ist.

2. Lichtempfindliche Mikrokapseln enthaltende Filmrolle nach Anspruch 1, bei der die Spule (6) in Hohlform ausgeführt ist und jede der Spulenendenhalterungen (12) in Hohlform ausgeführt ist.

3. Lichtempfindliche Mikrokapseln enthaltende Filmrolle nach Anspruch 2, bei dem jede der Spulenendenhalterungen auf ihrer einen Seite einen hohlen hervorragenden Abschnitt (12a) aufweist zum Einsetzen in ein jeweiliges Ende der Hohlspule (6) und auf ihrer anderen Seite einen hervorragenden Tragabschnitt (12c) aufweist, der sich in entgegengesetzter Richtung zu dem hohlen hervorragenden Abschnitt (12a) erstreckt.

4. Lichtempfindliche Mikrokapseln enthalende Filmrolle nach Anspruch 3, bei der jede der hohlen Halterungen (12) eine Blindscheibe (12b) zwischen dem hohlen hervorragenden Abschnitt (12a) und dem hervorragenden Tragabschnitt (12c) aufweist.

5. Lichtempfindliche Mikrokapseln enthaltende Filmrolle nach einem der vorhergehenden Ansprüche, bei der das Material, aus dem der Führungsbandabschnitt (15) gebildet ist, schwarzes Papier oder ein mit Aluminium beschichtetes Band ist.

6. Lichtempfindliche Mikrokapseln enthaltende Filmrolle nach einem der vorhergehenden Ansprüche, bei der der Führungsbandabschnitt (15) an seinen jeweiligen Seitenkanten mit dem Haftmittel (16) beschichtet ist.

7. Lichtempfindliche Mikrokapseln enthaltende Filmrolle nach einem der vorhergehenden Ansprüche, bei der die Breite des Führungsbandabschnitts (15) genauso groß wie der Abstand zwischen den Abschnitten der Flansche (11) ist, die sich von den Stufenabschnitten (13) radial nach außen erstrecken.

8. Lichtempfindliche Mikrokapseln enthaltende Filmrolle nach Anspruch 1, bei der der Führungsbandabschnitt (15) eine Beschichtung (18) mit schwarzer Farbe an einem Führungsendabschnitt des lichtempfindlichen Films (1) aufweist.

## Revendications

1. Rouleau de film de formation d'image comportant :
une bobine (6) avec, enroulée dessus, un film photosensible (1) sous la forme d'un rouleau;
une partie de bande d'amorce (15) réalisée dans une matière opaque et collée sur l'extrémité extérieure du film photosensible (1);
des supports d'extrémité de bobine (12) avec des flasques (11) prévus au niveau des extrémités opposées de la bobine (6); et
des parties d'épaulement dirigées vers l'intérieur (13) formées dans les flasques (11), la partie de bande d'amorce (15) du film photosensible (1) étant enroulée sur les parties d'épaulement (13) afin de protéger le film photosensible (1) contre la lumière, caractérisé en ce que;
ledit film photosensible (1) est revêtu de micro-capsules photosensibles; et
un agent de collage (16) est prévu entre les parties d'épaulement (13) et des bords latéraux respectifs de la partie de bande d'amorce (15).

2. Rouleau de film de formation d'image contenant des micro-capsules photosensibles selon la revendication 1, dans lequel la bobine (6) est réalisée avec une configuration creuse et chacun des supports d'extrémité de bobine (12) est d'une configuration creuse.

3. Rouleau de film de formation d'image contenant des micro-capsules photosensibles selon la revendication 2, dans lequel chacun des supports d'extrémité de bobine a sur un de ses côtés une partie saillante creuse (12a) devant être insérée dans une extrémité respective de la bobine creuse (6) et sur l'autre côté une partie d'épaulement saillante (12c) s'étendant dans une direction opposée la partie saillante creuse (12a).

4. Rouleau de film de formation d'image contenant des micro-capsules photosensibles selon la revendication 3, dans lequel chacun des supports creux (12) possède un disque d'obturation (12b) entre la partie saillante creuse et la partie d'épaulement (12c).

5. Rouleau de film de formation d'image contenant des micro-capsules photosensibles selon l'une quelconque des revendications 1 à 4, dans lequel la matière dans laquelle est formée la partie de bande d'amorce (15) est du papier noir ou une bande revêtue d'aluminium.

6. Rouleau de film de formation d'image contenant des micro-capsules photosensibles selon l'une quelconque des revendications 1 à 5, dans lequel la partie de bande d'amorce (15) est revêtue avec l'agent de collage (16) au niveau de ses bords latéraux respectifs.

7. Rouleau de film de formation d'image contenant des micro-capsules photosensibles selon l'une quelconque des revendications 1 à 6, dans lequel la largeur de la partie de bande d'amorce (15) est choisie afin d'être identique à la distance entre les parties des flasques (11) radialement à l'extérieur des parties d'épaulement (13).

8. Rouleau de film de formation d'image contenant des micro-capsules photosensibles selon la revendication 1, dans lequel la partie de bande d'amorce (15) comporte une couche de peinture noire (18) sur une partie d'extrémité terminale du film photosensible (10).
